# EUROPEAN PATENT APPLICATION

(11) **EP 4 510 194 A1**
(43) Date of publication of application: **19.02.2025**
(21) Application number: 23787993.7
(22) Date of filing: 26.01.2023
(51) Int. Cl.: H01L 29/78, H01L 29/12, H01L 21/336

(54) **SEMICONDUCTOR DEVICE AND METHOD FOR PRODUCING SAME**

(30) Priority: 14.04.2022 JP 2022066834
(71) Applicant: DENSO CORPORATION, Kariya-shi, Aichi 448-8661 (JP)
(72) Inventor: TAKAYA, Hidefumi, Kariya-shi, Aichi 448-8661 (JP)
(74) Representative: Kuhnen & Wacker Patent- und Rechtsanwaltsbüro PartG mbB
(86) International application number: PCT/JP2023/002514
(87) International publication number: WO 2023/199570

(57) **Abstract**

A semiconductor device 10 includes a plurality of p-type deep layers 36, a plurality of n-type deep layers 37, a drift layer 38 of n-type, and an n-type high concentration layer 39. The n-type high concentration layer is in contact with at least a part of a lower surface of a corresponding p-type deep layer in the plurality of p-type deep layers and has a higher concentration of n-type impurities than the drift layer.

## Description

### CROSS REFERENCE TO RELATED APPLICATION

This application is based on Japanese Patent Application. No. 2022-066834 filed on April 14, 2022 and claims priority based on this Japanese Patent Application. The entire contents described in this Japanese Patent Application are incorporated herein by reference.

### TECHNICAL FIELD

The techniques disclosed in the present specification relates to a semiconductor device and a method for producing the same.

JP 2003-309261 A and JP 2017-152488 A disclose semiconductor devices in which p-type layers and n-type layers are repeatedly and alternately arranged in a plane direction of a semiconductor substrate. When the semiconductor device is turned off, the p-type layers and the n-type layers are depleted and a voltage between a source and a drain is maintained.

### SUMMARY OF INVENTION

In such semiconductor devices including a plurality of p-type layers and a plurality of n-type layers, there is a trade-off relationship between on-resistance and breakdown voltage. The present specification proposes techniques to improve the trade-off relationship that exists between on-resistance and breakdown voltage.

A semiconductor device disclosed in the present specification can include a semiconductor substrate having an upper surface on which a trench is disposed, a gate insulating film covering an inner surface of said trench, and a gate electrode located in the trench and insulated from the semiconductor substrate by the gate insulating film. The semiconductor device can include a source layer of n-type being in contact with the gate insulating film on a side surface of the trench, a body layer of p-type being in contact with the gate insulating film on the side surface of the trench located below the source layer, a plurality of p-type deep layers each extending from the body layer to below a bottom surface of the trench, the plurality of p-type deep layers extending along a first direction and arranged at intervals in a second direction orthogonal to the first direction when the semiconductor substrate is viewed from above, a drift layer of n-type located below the plurality of p-type deep layers and the plurality of n-type deep layers and being in contact with the plurality of n-type deep layers, and an n-type high concentration layer being in contact with at least a part of a lower surface of a corresponding p-type deep layer in the plurality of p-type deep layers and having a higher concentration of n-type impurities than the drift layer.

In the above-described semiconductor device, the n-type high concentration layer is provided so as to be in contact with at least a part of the lower surface of the p-type deep layer, which restricts spreading of depletion layers from the p-type deep layers to the drift layer when the semiconductor device is turned on. Therefore, a wide current path is secured, so that the semiconductor device can have a characteristic of low on-resistance. In addition, the n-type high concentration layer is partially provided so as to be in contact with the lower surface of the p-type deep layer. Therefore, in the above-described semiconductor device, a breakdown voltage is also reduced. The above-described semiconductor device can achieve both low on-resistance and high breakdown voltage.

A manufacturing method of a semiconductor device disclosed in the present specification can include a deep layer forming process for forming a plurality of p-type deep layers and a plurality of n-type deep layers in an epitaxial layer of n-type, the plurality of p-type deep layers each extending along a first direction and arranged at intervals in a second direction orthogonal to the first direction when the epitaxial layer is viewed from above, each of the plurality of n-type deep layers located at a corresponding interval in a plurality of intervals defined between adjacent p-type deep layers in the plurality of p-type deep layers, and an n-type high concentration layer forming process for forming an n-type high concentration layer being in contact with at least a part of a lower surface of a corresponding p-type deep layer in the plurality of p-type deep layers and having a higher concentration of n-type impurities than the epitaxial layer. A chronological order of the deep layer forming process and the n-type high concentration layer forming process is not particularly limited.

According to this manufacturing method of the semiconductor device, it is possible to manufacture the semiconductor device that can achieve both low on-resistance and high breakdown voltage.

### BRIEF DESCRIPTION OF DRAWINGS

FIG. 1 is a perspective cross-sectional view of a semiconductor device 10 (a diagram showing an xz cross-section without p-type deep layers 36).
FIG. 2 is a perspective cross-sectional view of the semiconductor device 10 in which a source electrode 22 and an interlayer insulating film 20 are omitted (a diagram showing the xz cross-section without the p-type deep layers 36).
FIG. 3 is an enlarged xy cross-sectional view including p-type trench underlayers 35, the p-type deep layers 36 and n-type deep layers 37, and is an enlarged cross-sectional view of the semiconductor device 10 illustrating the arrangement of the p-type trench underlayers 35, the p-type deep layers 36 and the n-type deep layers 37 when the semiconductor substrate 12 is viewed from above.
FIG. 4 is an enlarged xy cross-sectional view including trenches 14, the p-type deep layers 36 and the n-type deep layers 37, and is an enlarged cross-sectional view of the semiconductor device 10 illustrating the arrangement of the trenches 14, the p-type deep layers 36 and the n-type deep layers 37 when the semiconductor substrate 12 is viewed from above.
FIG. 5 is a perspective cross-sectional view of the semiconductor device 10 (a diagram showing an xz cross-section with the p-type deep layers 36).
FIG. 6 is an enlarged yz cross-sectional view of a modification of the semiconductor device 10 that includes p-type deep layers 36, n-type deep layers 37, and n-type high concentration layers.
FIG. 7 is an enlarged yz cross-sectional view of a modification of the semiconductor device 10 that includes p-type deep layers 36, n-type deep layers 37, and n-type high concentration layers.
FIG. 8 is an enlarged yz cross-sectional view of a modification of the semiconductor device 10 that includes p-type deep layers 36, n-type deep layers 37, and n-type high concentration layers.
FIG. 9 is a diagram for explaining a manufacturing method of the semiconductor device 10.
FIG. 10 is a diagram for explaining the manufacturing method of the semiconductor device 10.
FIG. 11 is a diagram for explaining the manufacturing method of the semiconductor device 10.
FIG. 12 is a diagram for explaining the manufacturing method of the semiconductor device 10.
FIG. 13 is a diagram for explaining the manufacturing method of the semiconductor device 10.
FIG. 14 is a diagram for explaining the manufacturing method of the semiconductor device 10.
FIG. 15 is a diagram for explaining the manufacturing method of the semiconductor device 10.
FIG. 16 is a diagram for explaining the manufacturing method of the semiconductor device 10.

### DESCRIPTION OF EMBODIMENTS

Hereinafter, each embodiment will be described with reference to the drawings. For purposes of clarity of illustration, components that are arranged repeatedly are only partially assigned with reference numerals.

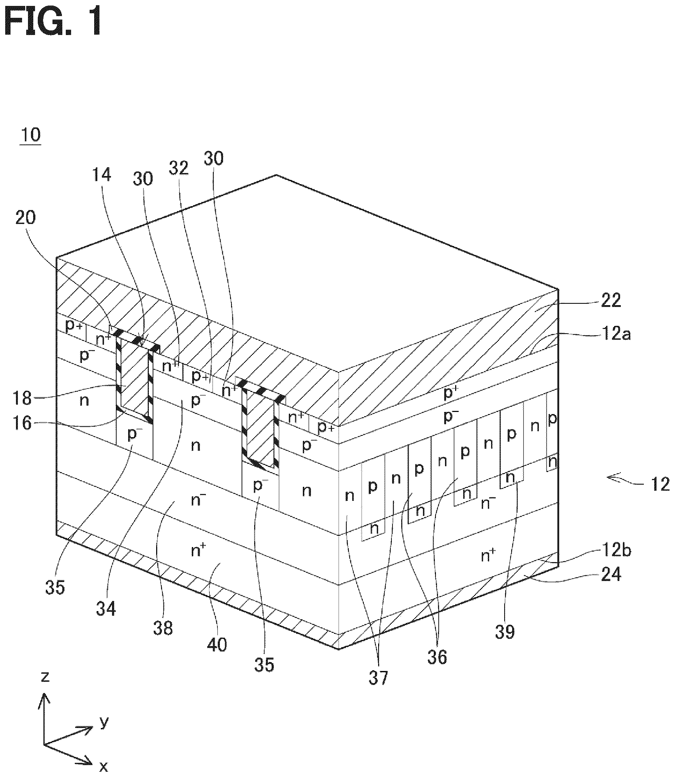

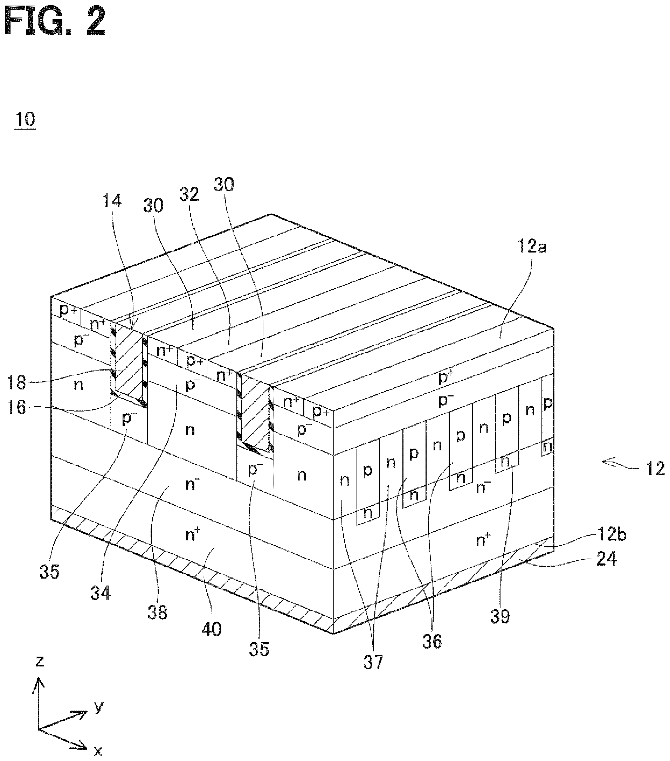

A semiconductor device 10 shown in FIGS. 1 to 5 is a type of power device called a metal-oxide-semiconductor field effect transistor (MOSFET) and includes a semiconductor substrate 12. In the following, a direction parallel to an upper surface 12a of the semiconductor substrate 12 may also be referred to as an x-direction, a thickness direction of the semiconductor substrate 12 may also be referred to as a z-direction, and a direction orthogonal to the x-direction and the z-direction may also be referred to as a y-direction. The semiconductor substrate 12 is made of silicon carbide (SiC). However, the semiconductor substrate 12 may also be made of other material such as silicon or gallium nitride. A plurality of trenches 14 is disposed on the upper surface 12a of the semiconductor substrate 12. As shown in FIG. 2, the trenches 14 extend in the y-direction on the upper surface 12a. The trenches 14 are arranged at intervals in the x-direction.

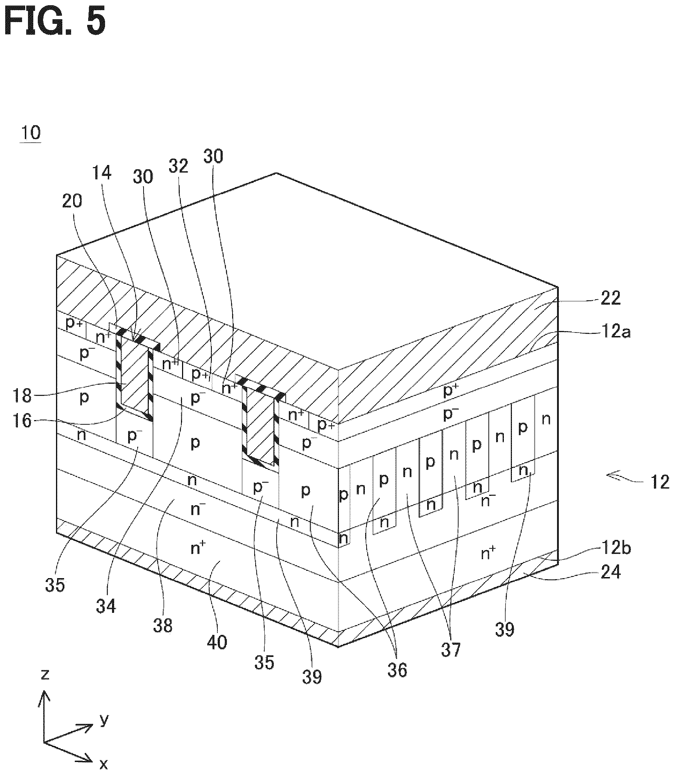

As shown in FIGS. 1, 2, and 5, an inner surface (that is, a bottom surface and a side surface) of each of the trenches 14 is covered with a gate insulating film 16. A gate electrode 18 is disposed in each of the trenches 14. The gate electrode 18 is insulated from the semiconductor substrate 12 by the gate insulating film 16. As shown in FIG. 1 and FIG. 5, an upper surface of each of the gate electrodes 18 is covered with an interlayer insulating film 20. A source electrode 22 is disposed on the semiconductor substrate 12. The source electrode 22 covers each of the interlayer insulating films 20. The source electrode 22 is insulated from the gate electrodes 18 by the interlayer insulating films 20. The source electrode 22 is in contact with the upper surface 12a of the semiconductor substrate 12 at portions where the interlayer insulating films 20 are not provided. A drain electrode 24 is disposed under the semiconductor substrate 12. The drain electrode 24 is in contact with the entire region of a lower surface 12b of the semiconductor substrate 12.

As shown in FIGS. 1, 2, and 5, the semiconductor substrate 12 includes a plurality of source layers 30, a plurality of contact layers 32, a body layer 34, a plurality of p-type trench underlayers 35, a plurality of p-type deep layers 36, a plurality of n-type deep layers 37, a drift layer 38, a plurality of n-type high concentration layers 39, and a drain layer 40.

Each of the source layers 30 is an n-type layer with a high concentration of n-type impurities. Each of the source layers 30 is disposed in a range partially including the upper surface 12a of the semiconductor substrate 12. Each of the source layers 30 is in ohmic contact with the source electrode 22. Each of the source layers 30 is in contact with the gate insulating film 16 at an uppermost portion of the side surface of the trench 14. Each of the source layers 30 faces the gate electrode 18 with the gate insulating film 16 interposed therebetween. Each of the source layers 30 extends in the y-direction along the side surface of the trench 14. Each of the source layers 30 extends in a direction parallel to the longitudinal direction of the trench 14 when the semiconductor substrate 12 is viewed from above, and extends from an end portion of the trench 14 to the other end portion of the trench 14 in the longitudinal direction.

Each of the contact layers 32 is a p-type layer with a high concentration of p-type impurities. Each of the contact layers 32 is disposed in a range partially including the upper surface 12a of the semiconductor substrate 12. Each of the contact layers 32 is disposed between two corresponding source layers 30. Each of the contact layers 32 is in ohmic contact with the source electrode 22. Each of the contact layers 32 extends in the y-direction. Each of the contact layers 32 extends in a direction parallel to the longitudinal direction of the trench 14 when the semiconductor substrate 12 is viewed from above, and extends from the end portion of the trench 14 to the other end portion of the trench 14 in the longitudinal direction.

The body layer 34 is a p-type layer with a lower concentration of p-type impurities than the contact layers 32. The body layer 34 is disposed below the source layers 30 and the contact layers 32. The body layer 34 is in contact with the source layers 30 and the contact layers 32 from below. The body layer 34 is in contact with the gate insulating film 16 on the side surface of the trench 14 located below the source layer 30. The body layer 34 faces the gate electrode 18 with the gate insulating film 16 interposed therebetween.

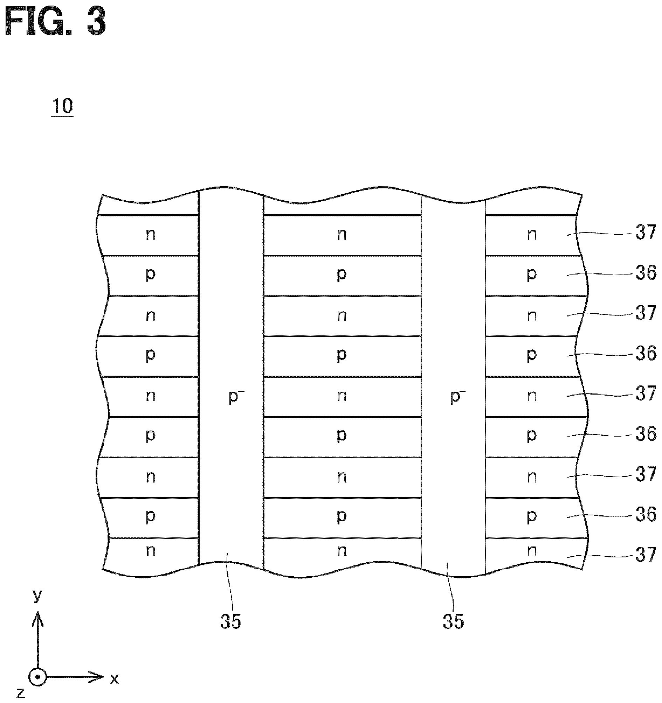

Each of the p-type trench underlayers 35 is a p-type layer located below the corresponding trench 14. As will be described later, each of the p-type trench underlayers 35 may be formed in an ion implantation process, which is common with the formation of the body layer 34. In this case, concentration profiles of p-type impurities in a depth direction of each of the p-type trench underlayers 35 and the body layer 34 are consistent. A depth from the bottom surface of the corresponding trench 14 to a lower surface of each of the p-type trench underlayers 35 matches a depth from the upper surface 12a of the semiconductor substrate 12 to a lower surface of the body layer 34. In this example, each of the p-type trench underlayers 35 is in contact with the gate insulating film 16 covering the bottom surface of the corresponding trench 14. As shown in FIG. 3, when the semiconductor substrate 12 is viewed from above, each of the p-type trench underlayers 35 may be elongated in the longitudinal direction of the corresponding trench 14 (the y-direction in this example), and may extend continuously from one end to the other of the trench 14 in the longitudinal direction.

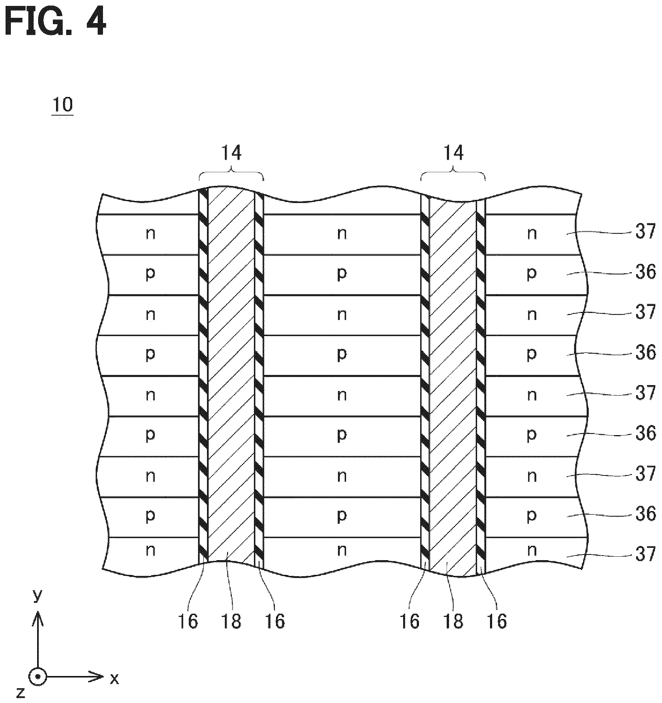

Each of the p-type deep layers 36 is a p-type layer protruding downward from the lower surface of the body layer 34. The concentration of p-type impurities in each of the p-type deep layers 36 is higher than the concentration of p-type impurities in the body layer 34 and lower than the concentration of p-type impurities in the contact layers 32. As shown in FIG. 4, when the semiconductor substrate 12 is viewed from above, each of the p-type deep layers 36 extends in the x-direction and is orthogonal to the longitudinal direction of the trenches 14 (the y-direction in this example). The p-type deep layer 36 are mutually arranged at intervals in the y-direction. Each of the p-type deep layers 36 has a shape elongated in the z -direction in the yz cross section. That is, the dimension of the p-type deep layers 36 in the z-direction (that is, the height of the p-type deep layers 36) is greater than the dimension of the p-type deep layers 36 in the y-direction (that is, the width of the p-type deep layers 36). Each of the p-type deep layer 36 extends from the lower surface of the body layer 34 to a depth below the bottom surface of each of the trenches 14. Each of the p-type deep layers 36 is in contact with the gate insulating film 16 on the side surface of each of the trenches 14 located below the body layer 34. As shown in FIG. 3, each of the p-type deep layers 36 is in contact with the p-type trench underlayers 35 located below the trenches 14 as to intersect the p-type trench underlayers 35.

Each of the n-type deep layers 37 is an n-type layer protruding downward from the lower surface of the body layer 34. The concentration of n-type impurities in each of the n-type deep layers 37 is higher than the concentration of n-type impurities in the drift layer 38. The n-type impurity concentration of each of the n-type deep layers 37 is lower than the p-type impurity concentration of each of the p-type deep layers 36. Instead of this example, each of the n-type deep layers 37 may have the same concentration as the n-type impurity concentration of the drift layer 38. As shown in FIGS. 1, 2, and 5, each of the n-type deep layers 37 is located at a corresponding interval in a plurality of intervals defined by the adjacent p-type deep layers 36. As shown in FIG. 4, when the semiconductor substrate 12 is viewed from above, each of the p-type deep layers 36 extends in the x-direction and is orthogonal to the longitudinal direction of the trenches 14 (the y-direction in this example). Each of the n-type deep layers 37 is in contact with the side surfaces of the p-type deep layer 36 on both sides thereof. Each of the p-type deep layers 36 has a shape elongated in the z-direction in the yz cross section. That is, the dimension of the n-type deep layers 37 in the z-direction (that is, the height of the n-type deep layers 37) is greater than the dimension of the n-type deep layers 37 in the y-direction (that is, the width of the n-type deep layers 37). In the present embodiment, the height of the n-type deep layers 37 is equal to the height of the p-type deep layers 36. In the present specification, the height of the n-type deep layers 37 and the p-type deep layers 36 are said to be the same if the difference in the height of the p-type deep layers 36 relative to the height of the n-type deep layers 37 is within 3%, taking into account variations in an ion implantation process. The width of the n-type deep layers 37 is approximately equal to the width of the p-type deep layers 36. As shown in FIGS. 1, 2, and 5, each of the n-type deep layers 37 extends from the lower surface of the body layer 34 to below the bottom surface of each of the trenches 14. Each of the n-type deep layers 37 is in contact with the gate insulating film 16 on the side surface of each of the trenches 14 located below the body layer 34. As shown in FIG. 3, each of the n-type deep layers 37 is in contact with the p-type trench underlayers 35 located below the trenches 14 as to intersect the p-type trench underlayers 35.

The drift layer 38 is an n-type layer located below the p-type deep layers 36 and the n-type deep layers 37. The concentration of n-type impurities in the drift layer 38 is lower than the concentration of n-type impurities in the n-type deep layers 37. The drift layer 38 is in contact with the n-type deep layers 37 from below.

Each of the n-type high concentration layers 39 is an n-type layer that is in contact with the entire lower surface of the corresponding p-type deep layer 36. The concentration of n-type impurities in each of the n-type high concentration layers 39 is higher than the concentration of n-type impurities in the drift layer 38. The concentration of n-type impurities in each of the n-type high concentration layer 39 may be lower than the concentration of n-type impurities in the n-type deep layers 37. Each of the n-type high concentration layers 39 is located between the drift layer 38 and the p-type deep layer 36, and separates the drift layer 38 and the p-type deep layer 36. Each of the n-type high concentration layers 39 is partially provided so as to be in contact with the lower surface of the p-type deep layer 36 and is not provided to cover at least part of the lower surface of the n-type deep layer 37. In other words, each of the n-type high concentration layers 39 does not extend continuously between the adjacent p-type deep layers 36, but is divided below the n-type deep layers 37. Therefore, the n-type deep layers 37 and the drift layer 38 are in contact in regions between adjacent n-type high concentration layers 39. When the semiconductor substrate 12 is viewed from above, each of the n-type high concentration layers 39 is elongated along the longitudinal direction of the corresponding p-type deep layer 36 (the y-direction in this example) and extends continuously from one end to the other end of the p-type deep layer 36 in the longitudinal direction. As shown in FIG. 5, each of the n-type high concentration layers 39 is also in contact with the lower surfaces of the p-type trench underlayers 35 that intersect the corresponding p-type deep layer 36 and is located between the drift layer 38 and the p-type trench underlayers 35. The adjacent n-type high concentration layers 39 may be connected to each other below the p-type trench underlayers 35. In this example, the n-type high concentration layers 39 may extend in the y-direction along the lower surfaces of the p-type trench underlayers 35 and may separate the drift layer 38 and the p-type trench underlayers 35.

The drain layer 40 is an n-type layer with a higher concentration of n-type impurities than the drift layer 38 and n-type deep layers 37. The drain layer 40 is in contact with the drift layer 38 from below. The drain layer 40 is arranged in a region including the lower surface 12b of the semiconductor substrate 12. The drain layer 40 is in ohmic contact with the drain electrode 24.

Next, the operation of the semiconductor device 10 will be described. The semiconductor device 10 is used in a state where a potential higher than a potential of the source electrode 22 is applied to the drain electrode 24. When a potential equal to or higher than a gate threshold value is applied to each of the gate electrodes 18, a channel is formed in the body layer 34 in the vicinity of the gate insulating film 16. The source layers 30 and the n-type deep layers 37 are connected by the channel. Therefore, electrons flow from the source layer 30 to the drain layer 40 through the channel, the n-type deep layers 37, and the drift layer 38. In other words, the semiconductor device 10 is turned on. When the potential of each of the gate electrodes 18 is reduced from a value equal to or higher than the gate threshold value to a value less than the gate threshold value, the channel disappears and the flow of electrons stops. In other words, the semiconductor device 10 is turned off.

If the n-type high concentration layers 39 are not provided, when the semiconductor device 10 is turned on, the depletion layers spread from the p-type deep layers 36 to the drift layer 38. In particular, if the depletion layers spread toward the drift layer 38 below the n-type deep layers 37, there is concern that a current path will narrow and on-resistance will increase. This increase in the on-resistance is called a JFET effect. On the other hand, in the semiconductor device 10, the n-type high concentration layers 39 are provided in contact with the lower surfaces of the p-type deep layers 36, which restricts the depletion layers from spreading from the p-type deep layers 36 to the drift layer 38. Therefore, a wide conduction path of current is secured, so that the semiconductor device 10 can have the characteristic of low on-resistance. The thickness of the n-type high concentration layers 39 may be greater than the thickness of depletion layers generated by built-in potential in pn junctions between the p-type deep layers 36 and the n-type high concentration layers 39. The JFET effect can be well restricted. The n-type high concentration layers 39 are partially provided below the p-type deep layers 36 and are not provided at least partially below the n-type deep layers 37, and are not continuously formed in the plane direction of the semiconductor substrate 12. Since the n-type high concentration layers 39 are partially provided, a reduction of the breakdown voltage of the semiconductor device 10 is also restricted. The semiconductor device 10 can achieve both low on-resistance and high breakdown voltage.

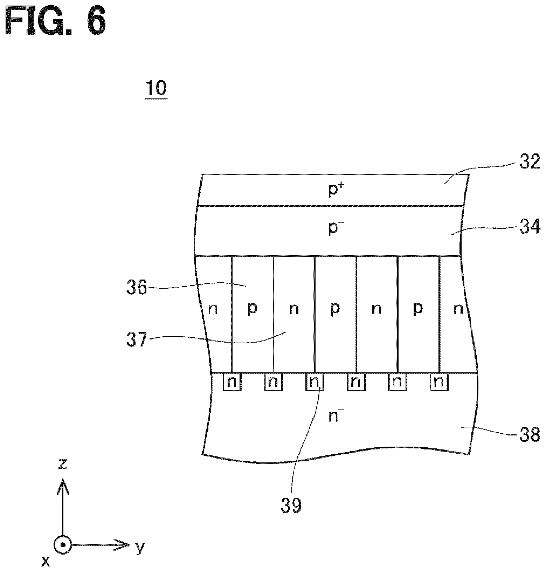

In a modification shown in FIG. 6, the n-type high concentration layers 39 are selectively located at both ends in the width direction of the lower surface of the corresponding p-type deep layers 36 and do not touch the entire lower surfaces of the p-type deep layers 36. Even in this modification, when the semiconductor device 10 is turned on, depletion layers can be restricted from spreading from the p-type deep layers 36 to the drift layer 38 below the n-type deep layers 37. Furthermore, since part of the p-type deep layers 36 is in contact with the drift layer 38, when the semiconductor device 10 is turned off, the depletion layers spread well from the p-type deep layers 36 to the drift layer 38. Therefore, the breakdown voltage can be improved in this modification.

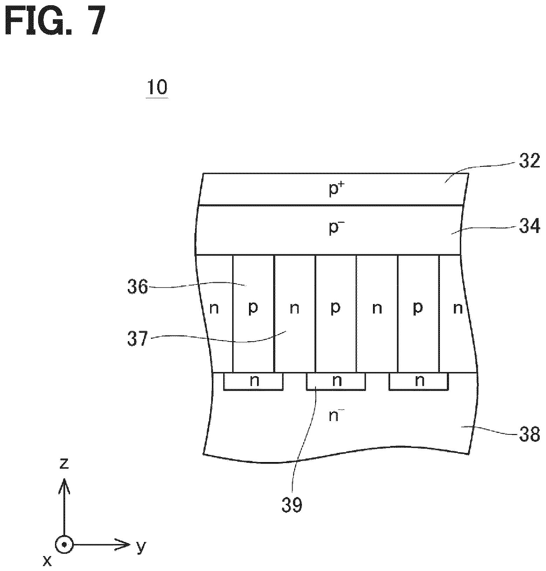

In a modification shown in FIG. 7, the width of the n-type high concentration layers 39 is greater than the width of the corresponding p-type deep layers 36. Accordingly, the n-type high concentration layers 39 are in contact the n-type deep layers 37 adjacent to the corresponding p-type deep layers 36, in addition to the entire lower surfaces of the corresponding p-type deep layers 36. According to this modification, when the semiconductor device 10 is turned on, it can be well restricted that the depletion layers spread from the p-type deep layers 36 to the drift layer 38.

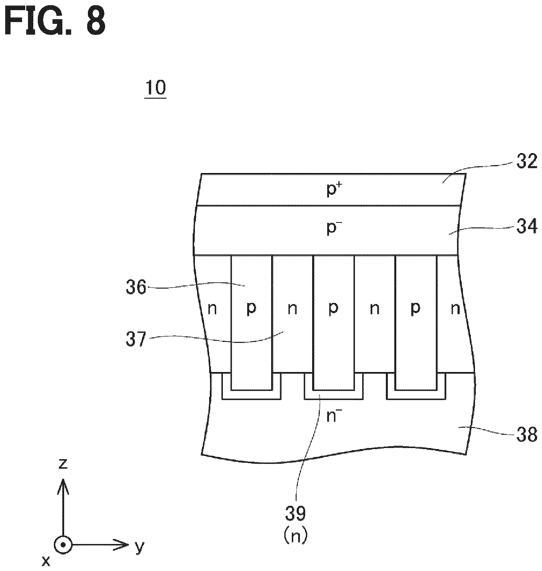

In a modification shown in FIG. 8, the p-type deep layers 36 extend below the n-type deep layers 37. The n-type high concentration layer 39 are in contact with the side surfaces of the p-type deep layers 36 located below the n-type deep layers 37, in addition to the entire lower surfaces of the p-type deep layers 36. When the p-type deep layers 36 extend below the n-type deep layers 37, the breakdown voltage of the semiconductor device 10 is improved. Since the n-type high concentration layers 39 are also located on the side surfaces of the p-type deep layers 36, even if the p-type deep layers 36 extend below the n-type deep layers 37, when the semiconductor device 10 is turned on, it can be restricted that depletion layers spread from the p-type deep layers 36 to the drift layer 38 below the n-type deep layers 37. This modification further improves the trade-off relationship that exists between on-resistance and the breakdown voltage. Also in this modification, as shown in FIG. 6, the semiconductor device 10 may be configured such that the n-type high concentration layers 39 are not provided on a part of the lower surfaces of the p-type deep layer 36, and the p-type deep layers 36 and the drift layer 38 are in contact with each other.

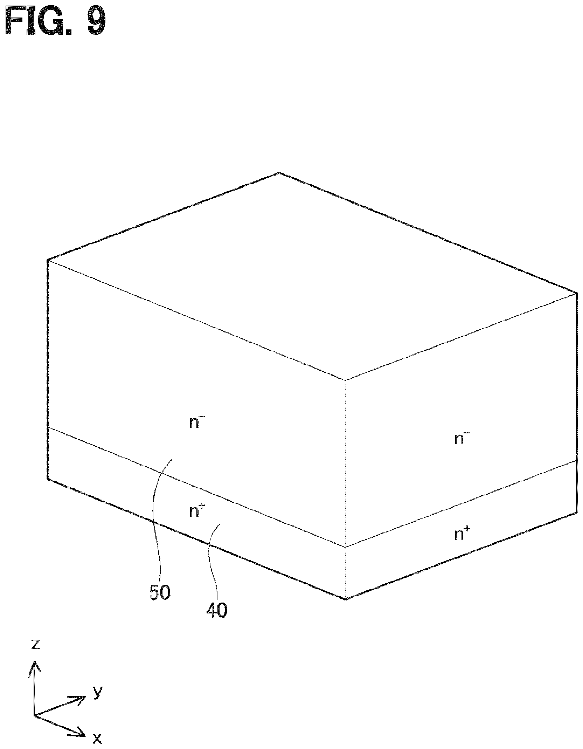

Next, a manufacturing method of the semiconductor device 10 will be described. The semiconductor device 10 is manufactured from a semiconductor substrate composed entirely of the drain layer 40. First, as shown in FIG. 9, an epitaxial layer 50 of n-type is formed on the drain layer 40 using an epitaxial growth technique.

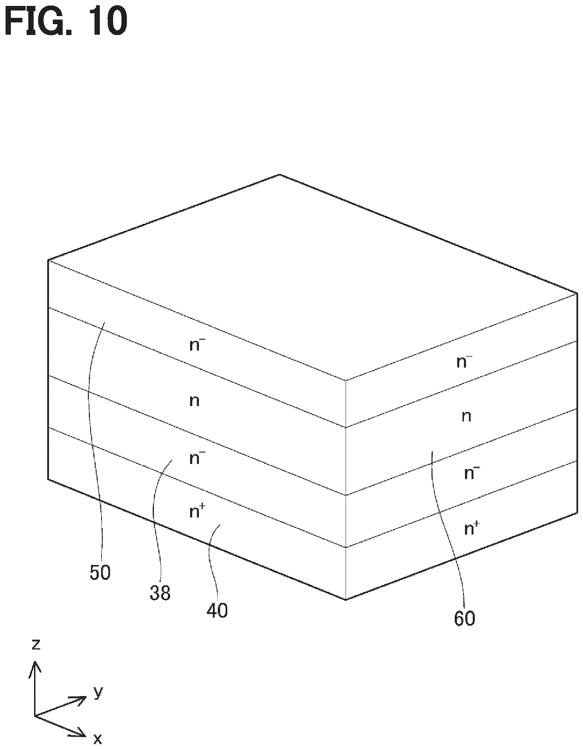

Next, as shown in FIG. 10, an n-type layer 60 is formed by introducing n-type impurities into a predetermined depth range away from a surface of the epitaxial layer 50 using an ion implantation technique. A portion of the epitaxial layer 50 located below the n-type layer 60 becomes the drift layer 38.

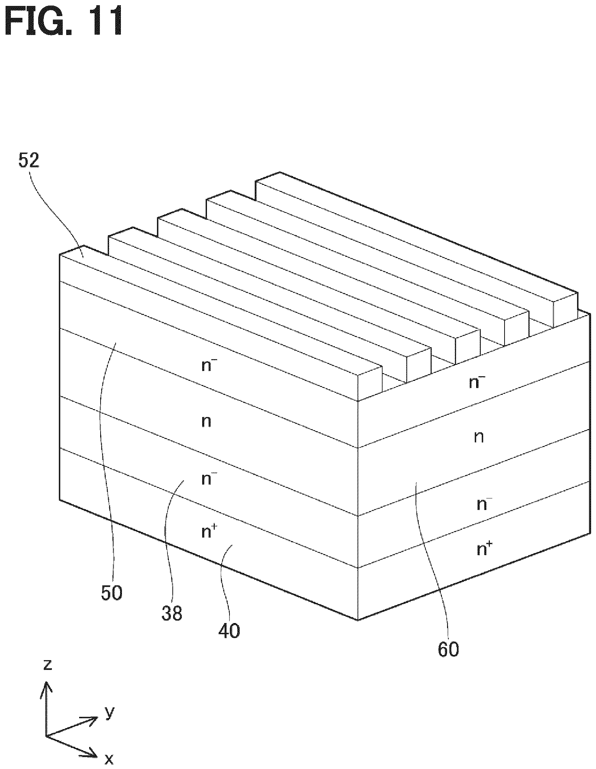

Next, as shown in FIG. 11, a mask 52 having opening portions is patterned on the epitaxial layer 50.

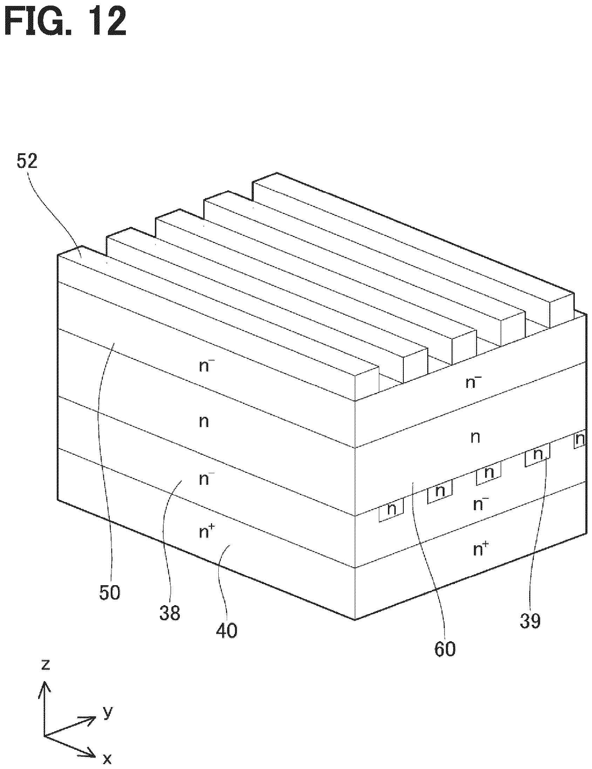

Next, as shown in FIG. 12, n-type impurities are introduced into upper portions of the drift layer 38 through the opening portions in the mask 52 using the ion implantation technique to form the n-type high concentration layers 39.

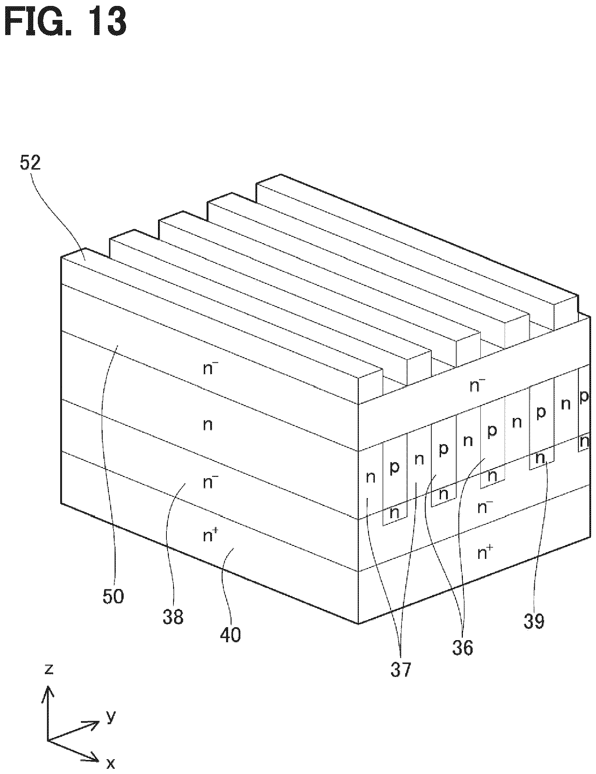

Next, as shown in FIG. 13, p-type impurities are introduced into portions of the n-type layer 60 through the opening portions in the mask 52 using the ion implantation technique to form the p-type deep layers 36. Portions of the n-type layer 60 where the p-type deep layers 36 are not formed become the n-type deep layers 37. In the present specification, the process of forming the p-type deep layers 36 and the n-type deep layers 37 in the processes illustrated in FIGS. 10 to 13 is an example of a deep layer forming process. After forming the p-type deep layers 36, the mask 52 is removed.

In this example, the mask 52 is used both as a mask for the ion implantation to form the n-type high concentration layers 39 and a mask for the ion implantation to form the p-type deep layers 36. This reduces the number of processes and manufacturing costs. The n-type high concentration layers 39 may be formed after the p-type deep layers 36 are formed. When the n-type high concentration layers 39 are formed, oblique ion implantation from a predetermined angle with respect to the upper surface of the epitaxial layer 50 can be used to form the modification of the n-type high concentration layers 39 shown in FIG. 6. Instead of using the mask 52 in common, an opening width of a mask for ion implantation to form the n-type high concentration layer 39 may be made greater than an opening width of a mask for ion implantation to form the p-type deep layers 36, so that the modification of the n-type high concentration layers 39 shown in FIG. 7 can be formed.

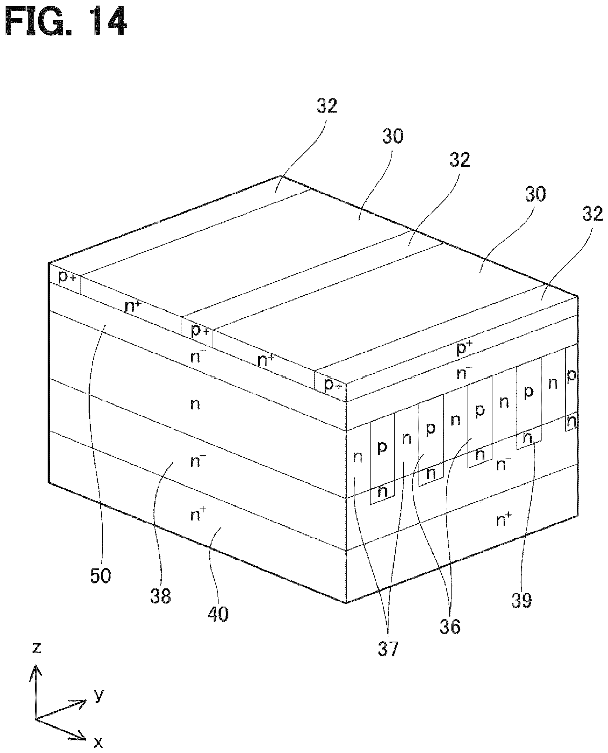

Next, as shown in FIG. 14, the source layers 30 and the contact layers 32 are formed by introducing the n-type impurities and the p-type impurities into a surface layer portion of the epitaxial layer 50 using the ion implantation technique.

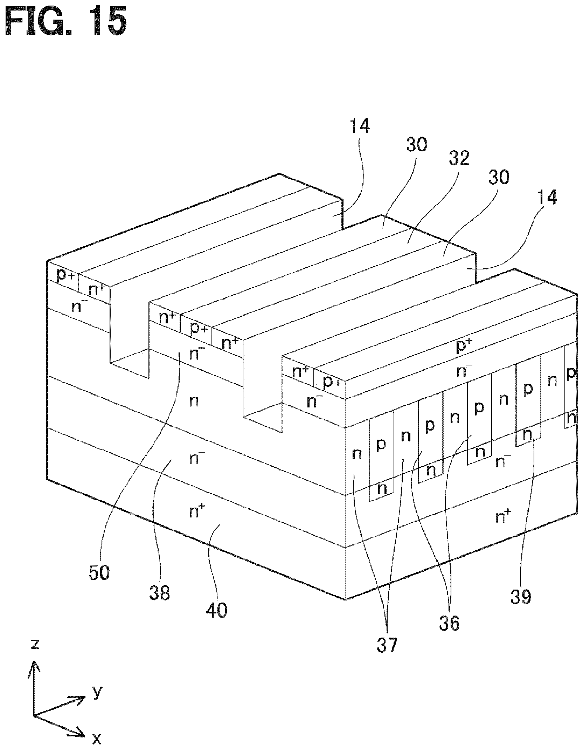

Next, as shown in FIG. 15, an etching technique is used to form the trenches 14 from the surface of the epitaxial layer 50 to the n-type deep layers 37 and p-type deep layers 36. The depth of trenches 14 is adjusted so as not to exceed the n-type deep layers 37 and p-type deep layers 36. Each of the trenches 14 intersects the p-type deep layers 36 and the n-type deep layers 37 when the epitaxial layer 50 is viewed from above.

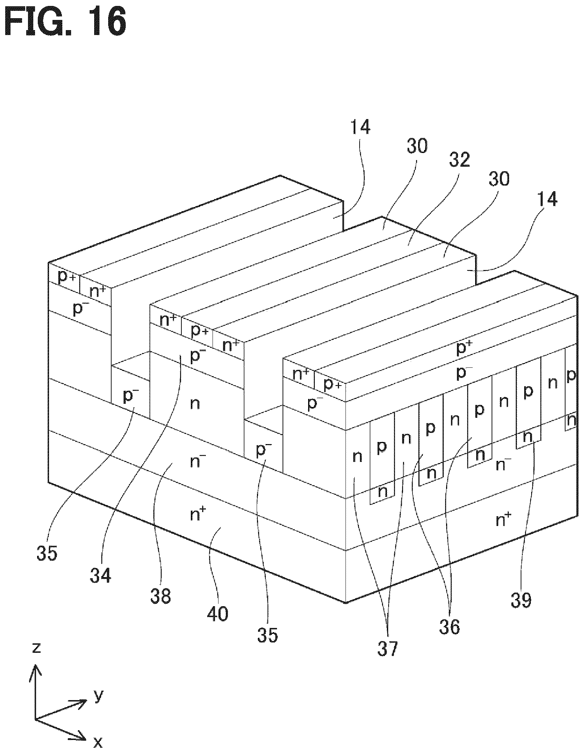

Next, as shown in FIG. 16, the body layer 34 and the p-type trench underlayers 35 are formed by introducing p-type impurities in multiple stages toward the surface of the epitaxial layer 50 using the ion implantation technique. The body layer 34 is formed above the n-type deep layers 37 and the p-type deep layers 36 and below the source layers 30 and the contact layers 32. The p-type trench underlayers 35 are formed below the bottom surfaces of the trenches 14.

Thereafter, the trenches 14, the gate insulating films 16, the gate electrodes 18, the interlayer insulating films 20, the source electrode 22, and the drain electrode 24 are formed. Accordingly, the semiconductor device 10 is completed.

Although the embodiments have been described in detail above, these are merely examples and do not limit the scope of claims. The techniques described in the claims include various modifications of the specific examples illustrated above. The technical elements described in the present specification or the drawings exhibit technical usefulness alone or in various combinations, and are not limited to the combinations described in the claims at the time of filing. In addition, the techniques illustrated in the present specification or drawings achieve objectives at the same time, and achieving one of the objectives itself has technical usefulness.

## Claims

1. A semiconductor device (10) comprising:
a semiconductor substrate (12) having an upper surface on which a trench (14) is disposed;
a gate insulating film (16) covering an inner surface of the trench; and
a gate electrode (18) disposed in the trench and insulated from the semiconductor substrate by the gate insulating film, wherein
the semiconductor substrate includes:
a source layer (30) of n-type being in contact with the gate insulating film on a side surface of the trench;
a body layer (34) of p-type being in contact with the gate insulating film on the side surface of the trench located below the source layer;
a plurality of p-type deep layers (36) each extending from the body layer to below a bottom surface of the trench, the plurality of p-type deep layers extending along a first direction and arranged at intervals in a second direction orthogonal to the first direction when the semiconductor substrate is viewed from above;
a plurality of n-type deep layers (37) each located at a corresponding interval in a plurality of intervals defined between adjacent p-type deep layers in the plurality of p-type deep layers, the plurality of n-type deep layers being in contact with the gate insulating film on the side surface of the trench located below the body layer;
a drift layer (38) of n-type located below the plurality of p-type deep layers and the plurality of n-type deep layers and being in contact with the plurality of n-type deep layers; and
an n-type high concentration layer (39) being in contact with at least a part of a lower surface of a corresponding p-type deep layer in the plurality of p-type deep layers and having a higher concentration of n-type impurities than the drift layer.

2. The semiconductor device according to claim 1, wherein
the n-type high concentration layer is in contact with at least both ends in the second direction of the lower surface of the corresponding p-type deep layer.

3. The semiconductor device according to claim 2, wherein
the n-type high concentration layer is in contact with an entire area of the lower surface of the corresponding p-type deep layer.

4. The semiconductor device according to claim 3, wherein
a width in the second direction of the n-type high concentration layer is greater than a width in the second direction of the corresponding p-type deep layer, and
the n-type high concentration layer is in contact with an n-type deep layer in the plurality of n-type deep layers located adjacent to the corresponding p-type deep layer.

5. The semiconductor device according to any one of claims 1 to 4, wherein the plurality of p-type deep layers extends below the plurality of n-type deep layers.

6. The semiconductor device according to claim 5, wherein
the n-type high concentration layer is also in contact with a side surface of the corresponding p-type deep layer located below the plurality of n-type deep layers.

7. The semiconductor device according to any one of claims 1 to 6, wherein the n-type high concentration layer has a lower concentration of n-type impurities than the plurality of n-type deep layers.

8. A manufacturing method of a semiconductor device (10), comprising:
a deep layer forming process for forming a plurality of p-type deep layers (36) and a plurality of n-type deep layers (37) in an epitaxial layer (50) of n-type, the plurality of p-type deep layers each extending along a first direction and arranged at intervals in a second direction orthogonal to the first direction when the epitaxial layer is viewed from above, each of the plurality of n-type deep layers located at a corresponding interval in a plurality of intervals defined between adjacent p-type deep layers in the plurality of p-type deep layers; and
an n-type high concentration layer forming process for forming an n-type high concentration layer being in contact with at least a part of a lower surface of a corresponding p-type deep layer in the plurality of p-type deep layers and having a higher concentration of n-type impurities than the epitaxial layer.

9. The manufacturing method of the semiconductor device according to claim 8, wherein
a mask for ion implantation to form the plurality of p-type deep layers in the deep layer forming process and a mask for ion implantation to form the n-type high concentration layer in the n-type high concentration layer forming process are common.

10. The manufacturing method of the semiconductor device according to claim 8, wherein
an opening width in the second direction of a mask for ion implantation to form the n-type high concentration layer in the n-type high concentration layer forming process is greater than an opening width in the second direction of a mask for ion implantation to form the plurality of p-type deep layers in the deep layer forming process.

11. The manufacturing method of the semiconductor device according to any one of claims 8 to 10, wherein
in the n-type high concentration layer forming process, the n-type high concentration layer is formed using an oblique ion implantation technique.

12. The manufacturing method of the semiconductor device according to any one of claims 8 to 11, wherein
the n-type high concentration layer has a lower concentration of n-type impurities than the plurality of n-type deep layers.
